# EUROPÄISCHE PATENTSCHRIFT

(11) **EP 3 054 146 B1**
(45) Veröffentlichungstag und Bekanntmachung des Hinweises auf die Patenterteilung: **10.07.2019**
(21) Anmeldenummer: 15202874.2
(22) Anmeldetag: 29.12.2015
(51) Int. Cl.: F02M 51/00, F02M 61/16, H01L 23/00

(54) **BAUTEILEVERBUND UND KRAFTSTOFFINJEKTOR**
COMBINATION OF COMPONENTS AND FUEL INJECTOR
COMBINAISON DE COMPOSANTS ET INJECTEUR DE CARBURANT

(30) Priorität: 04.02.2015 DE 102015201970
(43) Veröffentlichungstag der Anmeldung: 10.08.2016
(73) Patentinhaber: Robert Bosch GmbH, 70442 Stuttgart (DE)
(72) Erfinder: Grimminger, Christian, 71229 Leonberg (DE)

(56) Entgegenhaltungen:
- DE-A1-102006 029 966
- DE-A1-102009 002 909
- US-A1- 2010 252 001

## Beschreibung

### Stand der Technik

Die Erfindung betrifft einen Bauteilverbund sowie einen Kraftstoffinjektor.

Kabeldurchführungen oder medienempfindliche Bauteile im Bereich einer Schnittstelle zwischen metallischen Werkstoffen und einer Kunststoffumspritzung, wie sie beispielsweise bei einem als Kraftstoffinjektor ausgebildeten Bauteilverbund vorkommen, müssen derzeit technisch aufwändig geschützt werden. Hierzu ist es beispielsweise bekannt, durch separate Bauteile wie O-Ringe, Verschweißungen, Glasumschmelzungen oder ähnliches einen derartigen mediendichten Bauteilverbund auszubilden. Hintergrund für diese Maßnahmen ist die nicht vollständige Abdichtung zwischen einem aus metallischem Material bestehenden Element und Kunststoff, welche sich beispielsweise durch Kriechspalte sowie des Nichtanhaftens von Komponenten äußert.

Weiterhin ist es aus der nachveröffentlichten DE 10 2014 209 330 A1 der Anmelderin bekannt, in einer Ausnehmung eines Injektorgehäuses eines Kraftstoffinjektors eine Messeinrichtung mit einem Sensorelement anzuordnen. Mittels des Sensorelements lässt sich beispielsweise der Schließzeitpunkt einer Düsennadel erkennen, um damit die Ansteuerung des Kraftstoffinjektors zu optimieren. Das bekannte Sensorelement ist mittels einer Klebeverbindung mit der Ausnehmung verbunden und weist darüber hinaus elektrische Anschlussleitungen zur Kontaktierung des Sensorelements auf. Insbesondere der Bereich der Klebeverbindung zwischen dem Gehäuse des Kraftstoffinjektors und dem Sensorelement stellt einen zu schützenden Bereich dar, welcher vor dem Zutritt von Medien geschützt werden muss, die ansonsten die Haltbarkeit der Klebeverbindung herabsetzen können.

Weiter ist aus US 2010/0252001 A1 ein Kraftstoffinjektor bekannt, bei dem ein Sensorelement in einer Umhüllung angeordnet ist.

### Offenbarung der Erfindung

Ausgehend von dem dargestellten Stand der Technik liegt der Erfindung die Aufgabe zugrunde, eine Bauteileverbund mit möglichst einfachem Aufwand mediendicht zu gestalten, wobei eine relativ einfache konstruktive Ausgestaltung des Bauteileverbunds wünschenswert ist, um den Aufwand bzw. die Fertigungskosten relativ gering zu halten.

Diese Aufgabe wird erfindungsgemäß bei einem Bauteileverbund mit den Merkmalen des Anspruchs 1 im Wesentlichen dadurch gelöst, dass der zu schützende Bereich des Bauteileverbunds von einer Umhüllung umgeben ist, wobei in einem von der Umhüllung gebildeten Innenraum ein erstes Medium angeordnet ist, und wobei ein zweites Medium die Umhüllung zumindest bereichsweise umgibt. Es wird somit erfindungsgemäß ein aus drei Elementen bestehender Schutzaufbau vorgeschlagen, der zwei, insbesondere aus unterschiedlichen Materialen bestehende Medien aufweist, die voneinander durch eine Umhüllung getrennt sind.

Dabei ist es vorgesehen, dass durch das erste Medium ein von der Umhüllung gebildeter Innenraum, mit Ausnahme von im Innenraum angeordneten Elementen, vollständig ausgefüllt ist. Eine derartige Anordnung hat insbesondere den Vorteil, dass keine mit Luft, Flüssigkeit oder sonstigen schädlichen Medien befüllten Bereiche innerhalb des von der Umhüllung umschlossenen Innenraums ausgebildet werden, die insbesondere über die Lebensdauer der Anordnung betrachtet deren Haltbarkeit herabsetzen. Beispielsweise kann dann auch keine in einer Luftblase vorhandene Feuchtigkeit kondensieren, die dann beispielsweise Korrosion verursachen könnte.

Dieses erste Medium ist als vulkanisierendes Medium ausgebildet. Dabei wird, wie an sich bekannt, eine Kautschukmischung verwendet, welche mit Füllstoffen versetzt erhitzt wird. Dabei entsteht ein Gummi, welcher dauerelastische Eigenschaften aufweist, d.h. bei mechanischer Belastung wieder in seine Ursprungslage zurückkehrt. Insbesondere weist ein derartiges erstes Medium eine hohe Beständigkeit gegenüber Alterungs- und Witterungseinflüssen auf und eignet sich dadurch besonders gut zur Abdeckung bzw. zum Schutz eines entsprechenden, vor dem Zutritt von Medien zu schützenden Elements bzw. Bauteils der Anordnung.

In alternativer Ausgestaltung kann es auch vorgesehen sein, dass das erste Medium ein unter Wärme aushärtender und/oder temperaturbeständiger Klebstoff ist. Bei beiden Varianten wird der Vorteil erzielt, dass auch bei relativ hohen Temperaturen die benötigte Abschirm- bzw. Dichtwirkung des Klebstoffs nicht negativ beeinträchtigt wird.

Darüber hinaus ist es besonders bevorzugt, wenn das zweite Medium eine aus Kunststoff bestehende Umspritzung ist. Eine derartige Umspritzung hat insbesondere den Vorteil, dass sie relativ einfach lückenfrei im Bereich der Umhüllung bzw. eines zu schützenden Bauteils auf die Umhüllung bzw. auf das zu schützende Bauteil aufgebracht werden kann. Darüber hinaus hat eine Umspritzung die Eigenschaft, dass der erwärmte bzw. verflüssigte Kunststoff, der zum Ausbilden der Umspritzung dient, das innerhalb der Umhüllung befindliche erste Medium durch Vulkanisation bzw. durch Aushärten in seinen gewünschten Endzustand bringt.

Um das erste Medium und/oder eine elektrische Anschlussleitung möglichst einfach in dem Bereich der Umhüllung einzubringen, kann es vorgesehen sein, dass die Umhüllung wenigstens eine Öffnung zur Durchführung einer Leitung und/oder zum Einbringen des ersten Mediums in die Umhüllung aufweist. Insbesondere wird es dadurch ermöglicht, die Umhüllung zunächst mit einem Bauteil zu verbinden, und erst anschließend das erste Medium in den Innenraum der Umhüllung einzubringen.

Das erste Medium ist ein vulkanisierendes und/oder wärmeaushärtendes Medium und als zweites Medium wird ein im Spritzgussverfahren auf die Umhüllung aufbringbarer Kunststoff verwendet. Wie oben bereits erläutert hat die Verwendung eines im Spritzgussverfahren auf die Umhüllung aufbringbaren Kunststoffes insbesondere den Vorteil, dass dabei das erste Medium aushärtet bzw. vulkanisiert.

Besonders bevorzugt ist die Ausgestaltung des Bauteileverbunds als Kraftstoffinjektor, wobei der zu schützende Bereich ein Sensorelement oder eine Kabeldurchführung ist.

Weitere Vorteile, Merkmale und Einzelheiten der Erfindung ergeben sich aus der nachfolgenden Beschreibung bevorzugter Ausführungsbeispiele sowie anhand der Zeichnung.

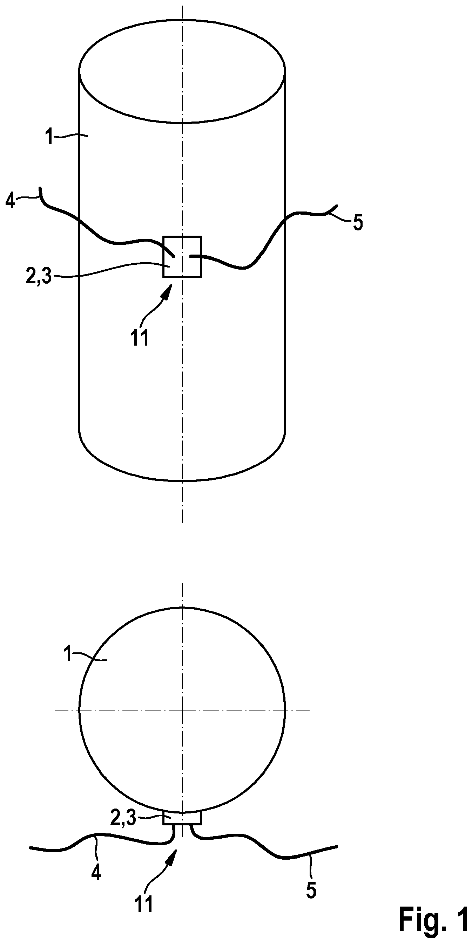

Diese zeigt in den
- Fig. 1 bis Fig. 4: jeweils in perspektivischer Ansicht sowie in einer Schnittdarstellung die Herstellung eines Bauteileverbunds, bei dem ein zu schützender Bereich mittels einer mediendichten Umhüllung versehen wird.

Gleiche Elemente bzw. Elemente mit gleicher Funktion sind in den Figuren mit den gleichen Bezugsziffern versehen.

In den Figuren ist ein Bauteileverbund 10 dargestellt, wie er beispielhaft zumindest ein erstes Bauteil 1 und ein zweites Bauteil 2 umfasst. Bei dem ersten Bauteil 1 kann es sich beispielsweise um ein metallisches Bauteil, wie ein Injektorgehäuse eines Kraftstoffinjektors handeln. Bei dem zweiten Bauteil 2 handelt es sich beispielhaft um ein Sensorelement 3, das über Leitungen 4, 5 elektrisch kontaktierbar ist. Beispielhaft kann das Sensorelement 3 der Detektion von Bauteilespannungen oder ähnlichem in oder an dem Kraftstoffinjektor dienen, wozu das zweite Bauteil 2 bzw. das Sensorelement 3 über eine in den Figuren im Einzelnen nicht dargestellte Klebeverbindung (alternativ ist eine sonstige geeignete Verbindungstechnik wie Schweißen oder Löten denkbar) mit der Oberfläche des ersten Bauteils 1 verbunden ist.

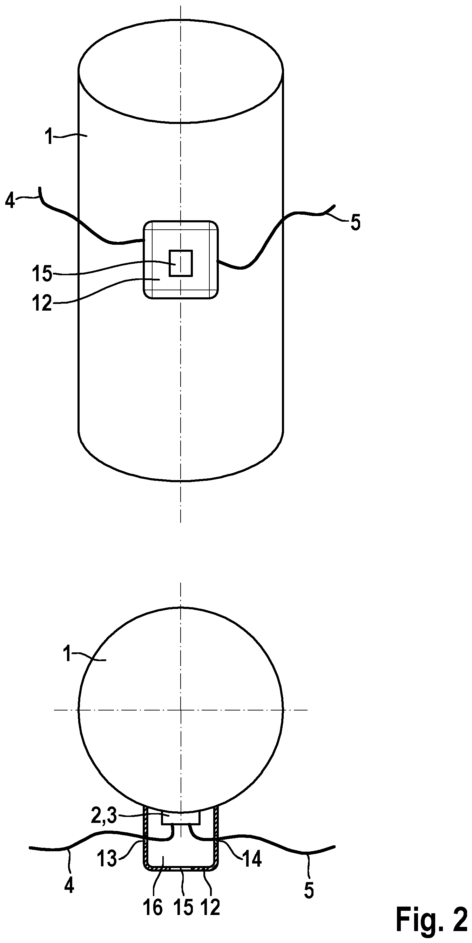

Der Bereich der Klebeverbindung bzw. das Sensorelement 3 stellt einen zu schützenden Bereich 11 dar, der vor dem Zutritt von Medien, die die Haltbarkeit bzw. Lebensdauer der Klebeverbindung herabsetzen könnte, geschützt werden muss. Hierzu ist es entsprechend der Figurenfolge der Fig. 1 bis 4 vorgesehen, dass zunächst in einem ersten Schritt, wie oben erläutert, das erste Bauteil 1 mit dem zweiten Bauteil 2, beispielsweise durch eine Klebeverbindung, verbunden wird. Anschließend erfolgt entsprechend der Darstellung der Fig. 2 in einem zweiten Schritt das Anbringen einer Umhüllung 12 an den zu schützenden Bereich 11.

Bei der Umhüllung 12 kann es sich beispielhaft um ein aus Metall bestehendes, topfförmiges Bauteil mit ersten Öffnungen 13, 14 zur Durchführung der Leitungen 4, 5 handeln. Weiterhin ist eine zweite Öffnung 15 in der Wand der Umhüllung 12 vorgesehen. Die Umhüllung 12 kann beispielsweise durch einen Löt- oder Schweißprozess, oder aber durch eine Klebeverbindung mit dem ersten Bauteil 1 verbunden werden. Weiterhin sind die beiden Leitungen 4, 5 durch die ersten Öffnungen 13, 14 hindurchgeführt.

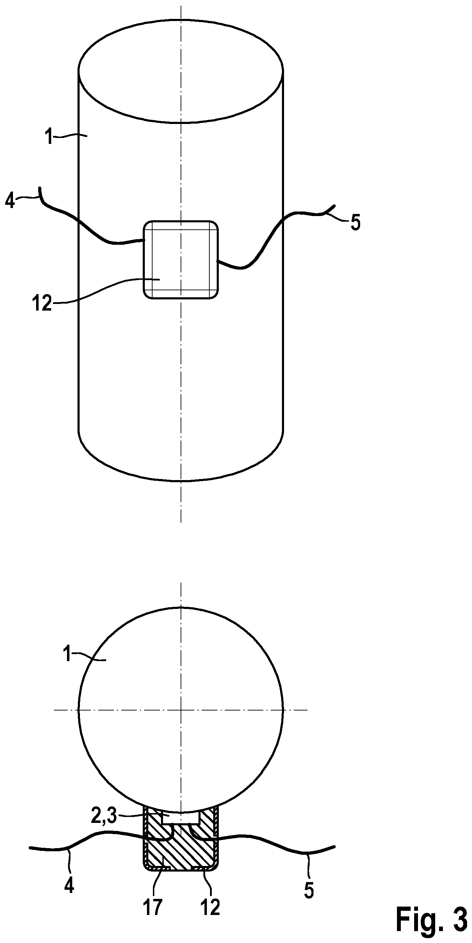

Anschließend erfolgt entsprechend der Darstellung der Fig. 3 in einem dritten Schritt das Einbringen eines ersten Mediums durch die zweite Öffnung 15 in den von der Umhüllung 12 zwischen der Umhüllung 12 und dem ersten Bauteil 1 ausgebildeten Innenraum 16. Im Bereich des Innenraums 16 ist ebenfalls der zu schützende Bereich 11 angeordnet. Bei dem ersten Medium 17 kann es sich beispielhaft um ein vulkanisierendes Medium oder um einen wärmeaushärtenden und/oder temperaturfesten Klebstoff handeln.

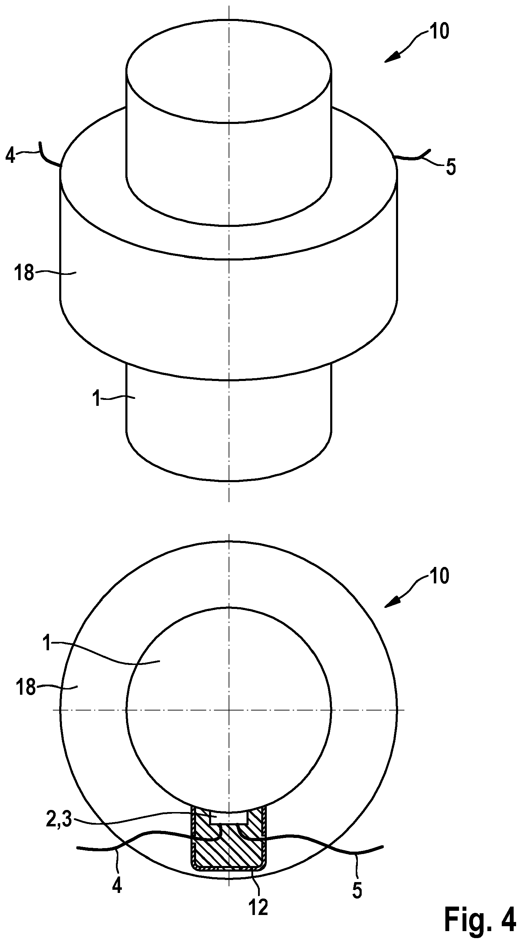

Nachdem das erste Medium 17 in den Innenraum 16 der Umhüllung 12 eingebracht wurde, wobei das Medium 17 den Innenraum 16 vollständig ausfüllt, derart, dass keine Lufteinschlüsse oder ähnliches sich im Bereich des Innenraums 16 befinden, erfolgt anschließend in dem in der Fig. 4 dargestellten vierten Schritt ein zumindest bereichsweises Umspritzen der Umhüllung 12 mittels eines zweiten Mediums 18. Bei dem zweiten Medium 18 handelt es sich um einen Kunststoff, welcher nach Erwärmung bzw. Verflüssigung im Spritzgussverfahren derart um den Bereich des ersten Bauteils 1 sowie der Umhüllung 12 angeordnet wird, dass die Umhüllung 12 vorzugsweise vollständig von dem Material des zweiten Mediums 18 umschlossen wird. Bei dem in der Fig. 4 dargestellten Ausführungsbeispiel umgibt das zweite Medium 18 darüber hinaus das erste Bauteil 1 in Form eines Rings.

## Patentansprüche

1. Bauteileverbund (10), mit einem zu schützenden Bereich (11) an wenigstens einem Bauteil (1, 2), wobei der zu schützende Bereich (11) von einer Umhüllung (12) umgeben ist, mit einem ersten, innerhalb der Umhüllung (12) angeordneten Medium (17), und mit einem zweiten, die Umhüllung (12) zumindest bereichsweise umgebenden Medium (18), **dadurch gekennzeichnet, dass** das erste Medium (17) ein vulkanisierendes Medium oder ein unter Wärme aushärtender und/oder temperaturbeständiger Klebstoff ist.

2. Bauteileverbund nach Anspruch 1,
**dadurch gekennzeichnet,**
**dass** das erste Medium (17) einen von der Umhüllung (12) gebildeten Innenraum (16), mit Ausnahme von im Innenraum (12) angeordneten Elementen (2, 3), vollständig ausfüllt.

3. Bauteileverbund nach einem der Ansprüche 1 oder 2,
**dadurch gekennzeichnet,**
**dass** das zweite Medium (18) eine aus Kunststoff bestehende Umspritzung ist.

4. Bauteileverbund nach einem der Ansprüche 1 bis 3,
**dadurch gekennzeichnet,**
**dass** die Umhüllung (12) wenigstens eine Öffnung (13 bis 15) zur Durchführung einer Leitung (4, 5) und/oder zum Einbringen des ersten Mediums (17) in die Umhüllung (12) aufweist.

5. Kraftstoffinjektor, aufweisend einen Bauteileverbund nach einem der Ansprüche 1 bis 4,
**dadurch gekennzeichnet,**
**dass** der zu schützende Bereich (11) ein Sensorelement (3) oder eine Kabeldurchführung ist.

## Claims

1. Component assembly (10), with a region (11) to be protected on at least one component (1, 2), the region (11) to be protected being surrounded at least in certain regions by an enclosure (12), with a first medium (17), arranged within the enclosure (12), and with a second medium (18), surrounding the enclosure (12), **characterized in that** the first medium (17) is a vulcanizing medium or a heat-curing and/or temperature-resistance adhesive.

2. Component assembly according to Claim 1,
**characterized**
**in that** the first medium (17) completely fills an interior space (16) formed by the enclosure (12), with the exception of elements (2, 3) arranged in the interior space (12).

3. Component assembly according to either of Claims 1 and 2,
**characterized**
**in that** the second medium (18) is an encapsulation consisting of plastic.

4. Component assembly according to one of Claims 1 to 3,
**characterized**
**in that** the enclosure (12) has at least one opening (13 to 15) for leading through a line (4, 5) and/or for introducing the first medium (17) into the enclosure (12).

5. Fuel injector, having a component assembly according to one of Claims 1 to 4,
**characterized**
**in that** the region (11) to be protected is a sensor element (3) or a cable bushing.

## Revendications

1. Assemblage de composants (10), avec une région à protéger (11) au niveau d'au moins un composant (1, 2), la région à protéger (11) étant entourée par une enceinte (12), avec un premier milieu (17) disposé à l'intérieur de l'enceinte (12) et un deuxième milieu (18) entourant au moins en partie l'enceinte (12), **caractérisé en ce que** le premier milieu (17) est un milieu vulcanisant ou est un adhésif thermodurcissable et/ou résistant à la température.

2. Assemblage de composants selon la revendication 1,
**caractérisé en ce que**
le premier milieu (17) remplit complètement un espace interne (16) formé par l'enceinte (12), à l'exception d'éléments (2, 3) disposés à l'intérieur de l'espace interne (12).

3. Assemblage de composants selon l'une quelconque des revendications 1 ou 2,
**caractérisé en ce que**
le deuxième milieu (18) est un surmoulage constitué de plastique.

4. Assemblage de composants selon l'une quelconque des revendications 1 à 3,
**caractérisé en ce que**
l'enceinte (12) présente au moins une ouverture (13 à 15) pour le passage d'une conduite (4, 5) et/ou pour l'introduction du premier milieu (17) dans l'enceinte (12).

5. Injecteur de carburant présentant un assemblage de composants selon l'une quelconque des revendications 1 à 4,
**caractérisé en ce que**
la région à protéger (11) est un élément de capteur (3) ou un passage de câbles.
